# EUROPEAN PATENT APPLICATION

(11) **EP 1 670 292 A1**
(43) Date of publication of application: **14.06.2006**
(21) Application number: 04791986.5
(22) Date of filing: 01.10.2004
(51) Int. Cl.: H05B 33/04, H05B 33/14

(54) **TRANSPARENT SEALING MATERIAL FOR ORGANIC EL DEVICE**

(30) Priority: 03.10.2003 JP 2003346262
(71) Applicant: JSR Corporation, Tokyo 104-8410 (JP)
(72) Inventor: SUZUKI, Masanori, c/o JSR Corporation, Tokyo 1048410 (JP); KAWATA, Takashi, c/o JSR Corporation, Tokyo 1048410 (JP); MIZOUCHI, Hiroyuki, c/o JSR Corporation, Tokyo 1048410 (JP); MORIKAWA, Akihiko, c/o JSR Corporation, Tokyo 1048410 (JP)
(74) Representative: TBK-Patent
(86) International application number: PCT/JP2004/014519
(87) International publication number: WO 2005/034583

(57) **Abstract**

The present invention provides a transparent sealant for organic EL element, which is excellent in flexibility and can seal the organic EL element sufficiently, and thus can suppress generation of dark spots thereby capable of enhancing visibility of an image when an organic EL display is produced. The transparent sealant for organic EL element 2 of the present invention is formed with a flexible polymer composition, and is disposed between the light emitting face of a light emitting element 3 and the sealing member 4 in an electroluminescence display panel 1 comprising the light emitting element 3 sequentially including a substrate 31, an anode layer 32, a light emitting layer 33 and a cathode layer 34, and a sealing member 4 disposed on the light emitting side of the light emitting element 3.

## Description

### [Technical Field]

The present invention relates to a transparent sealant for organic EL element. More particularly, the invention relates to a transparent sealant for organic EL element, which may be used for filling space on the light emitting face side of a light emitting element constituting an electroluminescence display panel (hereinafter, simply referred to as "EL display panel"). The transparent sealant for organic EL element of the present invention can be suitably used for EL display panels for use in mobile phones, portable access to information, desktop computers, laptop computers, televisions, in-vehicle information devices, watches, other various kinds of display apparatuses and the like.

### [Background Art]

A display apparatus having an EL element has high visibility since the EL element emits light itself. A high-performance display apparatus having an organic EL element, capable of lowering the voltage to be applied in comparison with an inorganic EL element, i.e., an organic EL display has been studied through utilizing such a property.
The organic EL element fundamentally has a configuration in which an anode layer, a light emitting layer and a cathode layer are formed on a substrate consisting of a glass or the like in this order. A functional layer is sometimes provided between each layer for the purpose of improving the performance.
Light emission of the organic EL element having the configuration as described above can be allowed by applying current between the anode layer and the cathode layer. However, when any moisture, impurity or the like is present around the element, the material constituting the element is invaded, thereby resulting in deterioration. In the case of using a display apparatus having thus deteriorated organic EL element, defects in light emission, i.e., dark spots may be generated, thereby leading to aggravation of visibility.

Furthermore, the display apparatus having an organic EL element generally comprises a transparent substrate made of a glass or the like (may be a sealing can) for covering the organic EL element to perfect sealing, or the like. In attempts to solve the aforementioned problems, a method in which a dehydrating agent is disposed in a space generated between the organic EL element and the transparent substrate, a method in which a transparent sealant consisting of an ultraviolet ray cured resin is used in the space, a method in which an inert liquid containing an adsorbent is filled (see, Patent Document 1) in the space, and the like are disclosed. However, suppression of generation of dark spots is insufficient according to any one of these methods. In addition, when a hard transparent sealant obtained by an ultraviolet ray curing resin is used, fixation of the transparent substrate or the sealing can may not be readily conducted in the steps of manufacturing the display apparatus. Further, unsatisfactory fixation may be achieved, thereby possibly resulting in insufficient sealing of the element.

[Patent Document 1] JP-A H9-35868

### [Disclosure of the Invention]

### [Problems to be solved by the Invention]

An objective of the present invention is to provide a transparent sealant for organic EL element, which is excellent in flexibility and can seal the organic EL element sufficiently, and thus can suppress generation of dark spots thereby capable of enhancing visibility of an image when an organic EL display is produced.

### [Means for solving problems]

The present invention is as follows.
[1] A transparent sealant for organic EL element, which is used in an electroluminescence display panel comprising a light emitting element sequentially including a substrate, an anode layer, a light emitting layer and a cathode layer, and a sealing member disposed on the light emitting side of the light emitting element, being characterized in that the transparent sealant for organic EL element is formed with a flexible polymer composition, and is disposed between the light emitting face of the light emitting element and the sealing member.
[2] The transparent sealant for organic EL element according to [1] above, wherein the total transmittance of the transparent sealant for organic EL element is 90% or higher when it has a thickness of 0.5 mm.
[3] The transparent sealant for organic EL element according to [1] above, wherein the flexible polymer composition is an elastomer composition.
[4] The transparent sealant for organic EL element according to [1] above, wherein the flexible polymer composition comprises at least one polymer selected from the group consisting of a diene-based polymer, an olefin-based polymer, an acrylic-based polymer, an urethane-based polymer, a polyamide-based polymer, a polyester-based polymer, a vinyl chloride-based polymer, a fluorine-based polymer and a silicone-based polymer.
[5] The transparent sealant for organic EL element according to [4] above, wherein the diene-based polymer is at least one polymer selected from the group consisting of a styrene • butadiene copolymer and hydrogenation thereof, a styrene • isoprene copolymer and hydrogenation thereof, a butadiene block copolymer and hydrogenation thereof, a styrene • butadiene • styrene block copolymer and hydrogenation thereof, and a styrene • isoprene • styrene block copolymer and hydrogenation thereof.
[6] The transparent sealant for organic EL element according to [4] above, wherein the diene-based polymer is a hydrogenation of a conjugated diene-based block polymer, in which the conjugated diene block polymer comprising, in its molecule, at least one butadiene polymer block (I) having a vinyl bond in an amount less than 25%, and at least one polymer block (II) having a mass ratio [(a1)/(a2)] of a conjugated diene unit (a1) and other monomer unit (a2) of (100 to 50)/(0 to 50) and having a vinyl bond in an amount from 25 to 95%, is hydrogenated.
[7] The transparent sealant for organic EL element according to [4] above, wherein the diene-based polymer is a hydrogenation of a conjugated diene-based block polymer, in which the conjugated diene block polymer comprising, in its molecule, at least one polymer block having a mass ratio [(b1)/(b2)] of a conjugated diene unit (b1) and an aromatic vinyl compound (b2) of (99 to 50)/(1 to 50), and having a vinyl bond in an amount from 65 to 95%, is hydrogenated.
[8] The transparent sealant for organic EL element according to [4] above, wherein the olefin-based polymer is at least one polymer selected from the group consisting of an ethylene • α-olefin copolymer and an ethylene • α-olefin • non-conjugated diene copolymer.
[9] The transparent sealant for organic EL element according to [8] above, wherein the ethylene•α-olefin copolymer and the ethylene•α-olefin•non-conjugated diene copolymer have a functional group selected from the group consisting of carboxyl group, hydroxyl group, epoxy group, amino group, alkoxysilyl group, sulfonic acid group and nitrile group.
[10] The transparent sealant for organic EL element according to [8] above, further comprising a metal ion and/or a metal compound.
[11] The transparent sealant for organic EL element according to [1] above, wherein the flexible polymer composition comprises a liquid material.
[12] The transparent sealant for organic EL element according to [11] above, wherein the kinematic viscosity of the liquid material at 40°C is 800 mm²/s or lower.
[13] The transparent sealant for organic EL element according to [11] above, wherein the content of the liquid material is in the range from 50 to 5000 parts by mass based on 100 parts by mass of total of the polymer in the flexible polymer composition.
[14] The transparent sealant for organic EL element according to [1] above, wherein the transparent sealant for organic EL element is a thin-walled body having a thickness at the thinnest part of 0.1 to 1,000 µm.

### [Effects of the Invention]

The transparent sealant for organic EL element of the present invention is formed with a flexible polymer composition. According to the transparent sealant for organic EL element of the present invention, the flexibility is excellent and the light emitting element can be sufficiently sealed without causing deterioration. As a consequence, generation of dark spots can be suppressed, thereby stabilizing the visibility of the image.
Since the transparent sealant for organic EL element of the present invention is also excellent in transparency, in the case where it is adhered to a transparent member such as a sealing member constituting an EL display panel, the transparency is not reduced. As a consequence, the visibility of an image is stabilized.
When the flexible polymer composition mentioned above is an elastomer composition, the transparent sealant shows sufficient flexibility in the case of producing a molded article having a desired shape. As a consequence, a space in the EL display panel can be filled without gap.
Moreover, when the flexible polymer composition contains a polymer selected from a diene-based polymer, an olefin-based polymer, an acrylic-based polymer, an urethane-based polymer, a polyamide-based polymer, a polyester-based polymer, a vinyl chloride-based polymer, a fluorine-based polymer and a silicone-based polymer, still more, when it contains a specific diene-based polymer or an olefin-based polymer, a transparent sealant for organic EL element having particularly high transparency can be provided. Furthermore, when a liquid material having a kinematic viscosity at a predetermined range is contained in the flexible polymer composition, a molded article that is more excellent in flexibility can be provided without reducing the transparency.
The transparent sealant for organic EL element of the present invention can be also formed into a thin-walled body. Even if it has such a shape, it is not easily ruptured or scratched.

### [Brief Description of the Drawings]

[Fig.1] It is an explanatory cross sectional view illustrating an EL display panel.
[Fig.2] It is an explanatory cross sectional view illustrating another EL display panel.
[Fig.3] It is an explanatory cross sectional view illustrating a light emitting element.

### [Description of Reference Numerals and Signs]

1; EL display panel, 2; transparent sealant for organic EL element, 3; light emitting element, 31; substrate, 32; anode layer, 33; light emitting layer, 34; cathode layer, 4; sealing member, 5; housing.

### [Best Mode for Carrying Out the Invention]

Hereinafter, the transparent sealant for organic EL element of the present invention is used in an electroluminescence display panel comprising a light emitting element (organic EL element) sequentially including a substrate, an anode layer, a light emitting layer and a cathode layer, and a sealing member disposed on the light emitting side of the light emitting element, is formed with a flexible polymer composition, and is disposed between the light emitting face of the light emitting element and the sealing member.

The transparent sealant for organic EL element of the present invention is formed with the flexible polymer composition described below. In the invention, the "flexible polymer composition" may include either the polymer as described below and other component, or the polymer alone. Therefore, the transparent sealant for organic EL element of the present invention may be formed either with a flexible polymer composition including the polymer as described below and other component, or with a flexible polymer composition constituted from the polymer alone.
It is preferred that the flexible polymer composition contains a polymer which has flexibility and provides a transparent molded article. The polymer to be contained may be either a resin or an elastomer (including a rubber). Additionally, a resin and an elastomer may be combined. In the present invention, the flexible polymer composition is preferably an elastomer composition. Examples of the polymer to be contained include an olefin-based polymer, a diene-based polymer, an acrylic-based polymer, an urethane-based polymer, a polyamide-based polymer, a polyester-based polymer, a vinyl chloride-based polymer, a fluorine-based polymer, a silicone-based polymer and the like. These may be used alone or in combination of two or more.

The diene-based polymer mentioned above is preferably a polymer prepared by using a conjugated diene. The diene-based polymer mentioned above may be a homopolymer or a copolymer, of a conjugated diene, or a copolymer of a conjugated diene and other monomer. Furthermore, as the diene-based polymer mentioned above, a homopolymer and a copolymer may be used in combination. Examples of the conjugated diene mentioned above include 1,3-butadiene, isoprene, 2,3-dimethyl-1,3-butadiene, 1,3-pentadiene, 2-methyl-1,3-pentadiene, 1,3-hexadiene, 4,5-diethyl-1,3-octadiene, chloroprene and the like. Among these, 1,3-butadiene, isoprene and 1,3-pentadiene are preferable. Particularly preferred are 1,3-butadiene and isoprene. The compounds mentioned above can be used alone or in combination of two or more.
Examples of the other monomer in the case where a copolymer is used include an aromatic vinyl compound such as styrene, t-butylstyrene, α-methylstyrene, α-chlorostyrene, p-methylstyrene, divinylbenzene and N,N-diethyl-p-aminostyrene; a cyanidated vinyl compound such as (meth)acrylonitrile; a nitrogen atom-containing vinyl compound such as vinylpyridine and the like. Among these, styrene and α-methylstyrene are preferable. The compounds mentioned above can be used alone or in combination of two or more. In the case the diene-based polymer mentioned above is a copolymer of a conjugated diene and other monomer, the conjugated diene unit may follow the distribution selected from random, taper (the monomer being increased or decreased along the molecular chain) and partial block.

Examples of the diene-based polymer mentioned above include polybutadiene, polyisoprene, styrene•butadiene copolymer, styrene•isoprene copolymer, isobutyrene•isoprene copolymer, acrylonitrile•butadiene copolymer and the like. Besides, a conjugated diene-based block copolymer such as styrene•butadiene•styrene block copolymer and styrene•isoprene•styrene block copolymer may be used.
This conjugated diene-based block copolymer may be a copolymer of a conjugated diene, or a copolymer of the conjugated diene mentioned above and one or more other monomers such as an aromatic vinyl compound. Therefore, examples of the block structure of this block copolymer include (A-B)ₘA, (B-A)ₘB, (A-B-A)ₘ, (B-A-B)ₘ and the like. Moreover, the block structure of this block copolymer may be one yielded by elongation or by branching of a molecular chain of the polymer via a residue X of a coupling agent, such as (A-B)ₘX, (B-A)ₘX, (A-B-A)ₘX, and (B-A-B)ₘX. In each general formula, "A" represents a block which has mainly a conjugated diene unit; "B" represents a block which has mainly another conjugated diene unit or other monomer unit and m represents an integer number of 1 or greater. Alternatively, the diene-based polymer according to the invention may be a hydrogenation of the polymer mentioned above (hydrogenated polymer). In the case of using the hydrogenation, the degree of hydrogenation thereof is preferably 80% or more, more preferably 85% or more and particularly preferably 90% or more. As the degree of hydrogenation is higher, light resistance, shape-retentive property and mechanical property can be improved when a molded article is provided.

A hydrogenation of a conjugated diene-based block polymer, or a hydrogenation of a diene-based polymer made of a conjugated diene and an aromatic vinyl compound is preferably used as the diene-based polymer mentioned above.

As the conjugated diene-based block polymer mentioned above, a diene-based block polymer (hereinafter, referred to as "polymer (P)") comprising, in its molecule, at least one butadiene polymer block (I) having a vinyl bond content of less than 25% and at least one polymer block (II) in which mass ratio [(a1)/(a2)] of the conjugated diene unit (a1) to the other monomer unit (a2) is (100-50)/(0-50) and the vinyl bond content is in the range from 25 to 95%, is preferred.

In the butadiene polymer block (I), the content of the vinyl bond (1,2-vinyl bond) is preferably less than 25%, more preferably from 5 to 20% and still preferably from 7 to 19%. Therefore, the butadiene polymer block (I) shall be a crystalline block exhibiting a structure that is similar to ethylene • butene copolymer through the hydrogenation. Mechanical property and shape-retentive property of a molded article can be improved by having the vinyl bond content at the above range.

Additionally, the polymer block (II) may be a block consisting of a conjugated diene unit alone, or a block consisting of a conjugated diene unit (a1) and other monomer unit (a2). The mass ratio [(a1)/(a2)] of the conjugated diene unit (a1) to the other monomer unit (a2) is preferably (100-50)/(0-50), more preferably (100-70)/(0-30) and still preferably (100-90)/(0-10). A molded article that is excellent in viscoelasticity can be provided by having the mass ratio at the range as such.
In the polymer block (II), the content of the vinyl bond (1,2-vinyl bond and 3,4-vinyl bond) is preferably from 25 to 95%, more preferably from 25 to 90%, and still preferably from 30 to 85%.

Therefore, as the polymer (P) mentioned above, one represented by (A¹-B¹)ₘ₁, (A¹-B¹)ₘ₂-A¹, (B¹-A¹)ₘ₃-B¹ or the like can be used when the butadiene polymer block (I) is denoted as "A¹", while the polymer block (II) is denoted as "B¹". In each general formula, m1 to m3 represents an integer number of 1 or more.
Additionally, in the case the polymer (P) is a copolymer having a block of not smaller than a triblock, a molded article that is more excellent in shape-retentive property and mechanical property can be provided when the polymer (P) is hydrogenated. Accordingly, in the above general formula, m1 is preferably an integer number of 2 or more.

The polymer (P) may have at least one butadiene polymer block (I) and at least one polymer block (II) in the molecule. And the polymer (P) may be a polymer having other block, for example, a block consisting of other monomer unit except for the conjugated diene unit.

The ratio [(I)/(II)] of the content of the butadiene polymer block (I) and the polymer block (II) constituting the polymer (P) is preferably (5-60)/(95-40), more preferably (7-55)/(93-45) and still preferably (7-50)/(93-50). In the case of having a content ratio of the blocks at the above range, a molded article that is excellent in shape-retentive property and mechanical property can be provided when the polymer (P) is hydrogenated.

As the diene-based polymer (hereinafter, referred to as "diene-based polymer (Q)") that is made of a conjugated diene and an aromatic vinyl compound, a diene-based polymer including at least one polymer block in which mass ratio [(b1)/(b2)] of the conjugated diene unit (b1) and the aromatic vinyl compound (b2) is (99-50)/(1-50) and the vinyl bond content is in the range from 65 to 95%, in its molecule, is preferred. In the case of using a diene-based polymer as such, a molded article that is excellent in viscoelasticity can be obtained.

Moreover, if the diene-based polymer (Q) is a copolymer having at least two polymer blocks made of an aromatic vinyl compound, a molded article that is more excellent in shape-retentive property and mechanical property can be provided when the polymer (Q) is hydrogenated.

In the diene-based polymer (Q), the content ratio [(I)/(II)] of the polymer block (I) made of an aromatic vinyl compound to the polymer block (II) made of a conjugated diene and an aromatic vinyl compound is preferably (1-40)/(99-60), more preferably (3-30)/(97-70) and still preferably (5-20)/(95-80). In the case of having a content ratio of the blocks at the above range, a molded article that is excellent in shape-retentive property and mechanical property can be provided when the polymer (Q) is hydrogenated. Therefore, as the diene polymer (Q) mentioned above, one represented by B¹, (A¹-B¹)ₘ₁, (A¹-B¹)ₘ₂-A¹, (B¹-A¹)ₘ₃₋B¹ or the like can be used when the polymer block (I) is denoted as "A¹", while the polymer block (II) is denoted as "B¹". In each general formula, m1 to m3 represent an integer number of 1 or more.

However, the polymer (P) and the diene-based polymer (Q) may be ones yielded by extending or branching of a polymer molecular chain via a residue X of a coupling agent, such as (A¹-B¹)ₙX, (B¹-A¹)ₙX, (A¹-B¹-A¹)ₙX and (B¹-A¹-B¹)ₙX. In each general formula, n represents an integer number of 2 or more. Additionally, in each general formula, when n is 3 or more, a molded article that is more excellent in shape-retentive property and hot-melt cohesion•adhesion properties can be provided when they are hydrogenated. Examples of the coupling agent include 1,2-dibromoethane, methyl dichlorosilane, trichlorosilane, methyl trichlorosilane, tetrachlorosilane, tetramethoxysilane, divinylbenzene, diethyl adipate, dioctyl adipate, benzene-1,2,4-triisocyanate, tolylene diisoisocyanate, epoxidized 1,2-polybutadiene, epoxidized linseed oil, tetrachlorogermanium, tetrachlorotin, butyltrichlorotin, butyltrichlorosilane, dimethylchlorosilane, 1,4-chloromethylbenzene, bis(trichlorosilyl)ethane and the like.

Hydrogenation (addition of hydrogen) of the polymer (P) and the diene-based polymer (Q) is executed on an olefinic unsaturated bond in the block. In the case of controlling degree of hydrogenation to higher, i.e., preferably 80% or more, more preferably 85% or more and particularly preferably 90% or more, light resistance, shape-retentive property and mechanical property can be improved when a molded article is obtained with the resulting hydrogenation. The hydrogenation of the polymer (P) and the diene-based polymer (Q) can be carried out by the method disclosed in JP-A Nos. H2-133406, H3-128957, H5-170844 and the like.

Further, the isobutylene • isoprene copolymer mentioned above is generally used as "butyl rubber", however, it may be a copolymer of isobutylene and isoprene with still other monomer, e.g., a compound having a polar group (hereinafter, may be also referred to as "polar group-containing compound"). Moreover, the isobutylene • isoprene copolymer may be a partially crosslinked copolymer by means of this polar group-containing compound or the like.

As the polar group-containing compound, a compound having at least one selected from hydroxyl group, epoxy group, amino group, carboxyl group, acid anhydride group, alkoxysilyl group, nitrile group and the like can be used. In addition, the partially crosslinked copolymer is usually obtained by copolymerization of such a polar group-containing compound with a compound having a polyfunctional unsaturated bond. Examples of this compound include a polyvalent allyl compound, a polyvalent (meth)acrylate compound, a divinyl compound, a bismaleimide compound, a dioxime compound and the like.

The butyl rubber may be a chlorinated isobutylene•isoprene copolymer, a brominated isobutylene•isoprene copolymer or the like obtained by halogenation of an isobutylene•isoprene copolymer, and the like.

Examples of the olefin-based polymer mentioned above include polyethylene, polypropylene, ethylene•α-olefin copolymer, ethylene•α-olefin•non-conjugated diene copolymer and the like. However, the α-olefin in the ethylene•α-olefin copolymer and the ethylene•α-olefin•non-conjugated diene copolymer is α-olefin except ethylene. Examples of this α-olefin includes propylene, 1-butene, 1-pentene, 3-methyl-1-butene, 1-hexene, 3-methyl-1-pentene, 4-methyl-1-pentene, 3-ethyl-1-pentene, 1-octene, 1-decene, 1-undecene and the like. Among these, α-olefin having 3 to 12 carbon atoms is preferable. Particularly propylene and 1-butene are preferable. The α-olefin mentioned above can be used alone or in combination of two or more.
Examples of the ethylene•α-olefin copolymer mentioned above include ethylene•propylene copolymer, ethylene•1-butene copolymer, ethylene•1-pentene copolymer, ethylene•3-methyl-1-butene copolymer, ethylene•1-hexene copolymer, ethylene•3-methyl-1-pentene copolymer, ethylene•4-methyl-1-pentene copolymer, ethylene•3-ethyl-1-pentene copolymer, ethylene•1-octene copolymer, ethylene•1-decene copolymer, ethylene•1-undecene copolymer and the like. Among these, ethylene•propylene copolymer and ethylene•1-butene copolymer are preferable. The ethylene•α-olefin copolymer mentioned above can be used alone or in combination of two or more.

In addition, examples of the non-conjugated diene for the ethylene•α-olefin•non-conjugated diene copolymer include 1,4-pentadiene, 1,4-hexadiene, 1,5-hexadiene, 1,7-octadiene, 1,9-decadiene, 3,6-dimethyl-1,7-octadiene, 4,5-dimethyl-1,7-octadiene, 5-methyl-1,8-nonadiene, dicyclopentadiene, 5-ethylidene-2-norbornene, 5-vinyl-2-norbornene, 2,5-norbornadiene and the like. These can be used alone or in combination of two or more.
Examples of the ethylene•α-olefin•non-conjugated diene copolymer mentioned above include ethylene•propylene•dicyclopentadiene copolymer, ethylene•propylene•5-ethylidene-2-norbornene copolymer, ethylene•1-butene•dicyclopentadiene copolymer, ethylene•1-butene•5-ethylidene-2-norbornene copolymer and the like. These can be used alone or in combination of two or more.

Further, each of the ethylene • α-olefin copolymer and the ethylene • α-olefin • unconjugated diene copolymer may be a polymer comprising a monomer unit formed from other monomer (a) in the polymer. Preferred other monomer (a) is an unsaturated compound having a functional group such as carboxyl group, hydroxyl group, epoxy group, amino group, alkoxysilyl group, sulfonic acid group and nitrile group. The unsaturated compound as such can be used alone or in combination of two or more. In addition, the amount of the unsaturated compound to be used is preferably 0.01 to 10% by mass and more preferably 0.1 to 5% by mass based on the total monomers.

Examples of the unsaturated compound having carboxyl group include maleic anhydride, (meth)acrylic acid, a cyclic compound represented by the following general formula (1), and the like. 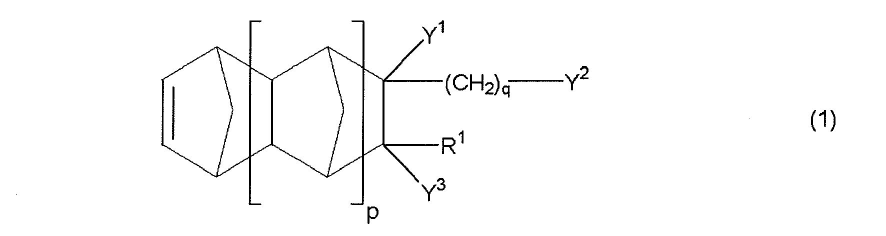 (In the above general formula (1), R¹ represents a hydrogen atom or a hydrocarbon group of 1 to 10 carbons; each of Y¹, Y² and Y³ represents independently a hydrogen atom, a hydrocarbon group of 1 to 10 carbons or -COOH; at least one of Y¹, Y² and Y³ is -COOH; in a case where two or more of Y¹, Y² and Y³ are -COOH, these may be an acid anhydride (-CO-(O)-CO-) formed by linkage with one another; p represents an integer number of 0 to 2; and q represents an integer number of 0 to 5.)

Examples of the cyclic compound represented by the above general formula (1) include 5,6-dimethyl-5,6-dicarboxy-bicyclo[2.2.1]-2-heptene, 5,6-diethyl-5,6-dicarboxy-bicyclo[2.2.1]-2-heptene, 5,6-dimethyl-5,6-bis(carboxymethyl)-bicyclo[2.2.1]-2-heptene, 5,6-diethyl-5,6-bis(carboxymethyl)-bicyclo[2.2.1]-2-heptene, 5-methyl-5-carboxy-bicyclo[2.2.1]-2-heptene, 5-ethyl-5-carboxy-bicyclo[2.2.1]-2-heptene, 5-carboxy-5-carboxymethyl-bicyclo[2.2.1]-2-heptene, 5-methyl-5-carboxymethyl-bicyclo[2.2.1]-2-heptene, 5-ethyl-5-carboxymethyl-bicyclo[2.2.1]-2-heptene, 8,9-dimethyl-8,9-dicarboxy-tetracyclo[4.4.0.1^{2,5}.1^{7,10}]-3-dodecene, 8,9-diethyl-8,9-dicarboxy-tetracyclo[4.4.0.1^{2,5}.1^{7,10}]-3-dodecene, 8-methyl-8-carboxy-tetracyclo[4.4.0.1^{2,5}.1^{7,10}]-3-dodecene, 8-ethyl-8-carboxy-tetracyclo[4.4.0.1^{2,5}.1^{7,10}]-3-dodecene and the like. These can be used alone or in combination of two or more.

When the cyclic compound represented by the above general formula (1) is used, the amount to be used is preferably 0.01 to 15% by mass and more preferably 0.1 to 10% by mass based on the total monomers.
It is preferred that the ethylene • α-olefin copolymer and the ethylene • α-olefin • unconjugated diene copolymer obtained by copolymerization of the cyclic compound represented by the above general formula (1) are a random copolymer. Furthermore, the weight average molecular weight Mw of the random copolymer obtained by copolymerization, in terms of polystyrene by GPC is preferably from 1,000 to 3,000,000, more preferably from 3,000 to 1,000,000 and still preferably from 5,000 to 700,000.

As the olefin-based polymer according to the present invention, each of the ethylene•α-olefin copolymer and ethylene•α-olefin•unconjugated diene copolymer exemplified above may be used alone or in combination of two or more.

The acrylic-based polymer includes a polymer obtained with monomers containing an acrylic acid alkyl ester, and the like.
Examples of the acrylic acid alkyl ester mentioned above include methyl acrylate, ethyl acrylate, n-propyl acrylate, n-butyl acrylate, isobutyl acrylate, n-pentyl acrylate, isoamyl acrylate, n-hexyl acrylate, 2-methylpentyl acrylate, n-octyl acrylate, 2-ethylhexyl acrylate, n-decyl acrylate, n-dodecyl acrylate, n-octadecyl acrylate, cyanomethyl acrylate, 1-cyanoethyl acrylate, 2-cyanoethyl acrylate, 1-cyanopropyl acrylate, 2-cyanopropyl acrylate, 3-cyanopropyl acrylate, 4-cyanobutyl acrylate, 6-cyanohexyl acrylate, 2-ethyl-6-cyanohexyl acrylate, 8-cyanooctyl acrylate and the like. These can be used alone or in combination of two or more.

The acrylic-based polymer mentioned above may be either a resin or a rubber so long as it is a copolymer of an acrylic acid alkyl ester and other monomer. In the case the acrylic-based polymer mentioned above is, for example, an acrylic rubber, an acrylic acid alkoxyalkyl ester, an ethylenic unsaturated compound, a crosslinkable compound and the like can be used as the other monomer.
Examples of the acrylic acid alkoxyalkyl ester mentioned above include 2-methoxyethyl acrylate, 2-ethoxyethyl acrylate, 2-(n-propoxy)ethyl acrylate, 2-(n-butoxy)ethyl acrylate, 3-methoxypropyl acrylate, 3-ethoxypropyl acrylate, 2-(n-propoxy)propyl acrylate, 2-(n-butoxy)propyl acrylate and the like.

Examples of the ethylenic unsaturated compound mentioned above include a compound having carboxyl group such as acrylic acid, methacrylic acid, crotonic acid, 2-pentenoic acid, maleic acid, fumaric acid and itaconic acid; a fluorine-containing acrylate ester such as 1,1-dihydroperfluoroethyl (meth)acrylate, 1,1-dihydroperfluoropropyl (meth)acrylate, 1,1,5-trihydroperfluorohexyl (meth)acrylate, 1,1,2,2-tetrahydroperfluoropropyl (meth)acrylate, 1,1,7-trihydroperfluoroheptyl (meth)acrylate, 1,1-dihydroperfluorooctyl (meth)acrylate and 1,1-dihydroperfluorodecyl (meth)acrylate; a compound having hydroxyl group such as 1-hydroxypropyl (meth)acrylate, 2-hydroxypropyl (meth)acrylate and hydroxyethyl (meth)acrylate; a monomer having tertiary amino group such as diethylaminoethyl (meth)acrylate and dibutylaminoethyl (meth)acrylate; a methacrylic acid ester such as methyl methacrylate and octyl methacrylate; an alkylvinyl ketone such as methylvinyl ketone; a vinyl and allyl ether such as vinylethyl ether and allylmethyl ether; an aromatic vinyl compound such as styrene, α-methylstyrene, chlorostyrene and vinyltoluene; a cyanidated vinyl compound such as acrylonitrile and methacrylonitrile; ethylene, propylene, butene, vinyl chloride, vinylidene chloride, vinyl fluoride, vinylidene fluoride, vinyl acetate, vinyl propionate, alkyl fumarate and the like.

Examples of the crosslinkable compound mentioned above include a diene-based compound, a (meth)acrylic acid ester having dihydrodicyclopentadienyl group, an ethylenic unsaturated compound having epoxy group, an active halogen-containing ethylenic unsaturated compound, an ethylenic unsaturated compound having carboxyl group, an ethylenic unsaturated compound having active hydrogen group and the like.

Examples of the urethane-based polymer include one obtained by a reaction of an organic diisocyanate, a high molecular weight diol and a chain extension agent, and the like.
Examples of the organic diisocyanate include an aromatic diisocyanate such as 4,4'-diphenylmethane diisocyanate, tolylene diisocyanate, 1,5-naphthylene diisocyanate, xylylene diisocyanate, phenylene diisocyanate and 3,3'-dichloro-4,4'-diphenylmethane diisocyanate; an aliphatic or an alicyclic diisocyanate such as hexamethylene diisocyanate, isophorone diisocyanate, 4,4'-dicyclohexylmethane diisocyanate and hydrogenated xylylene diisocyanate, and the like. The organic diisocyanate can be used alone or in combination of two or more.

In addition, examples of the high molecular weight diol include a polyester diol, a polyether diol, a polycarbonate diol, a polyester polycarbonate diol, a polyester polyether diol and the like.
Among these, examples of the polyester diol include an aliphatic polyester diol obtained by a reaction of an aliphatic diol and an aliphatic dicarboxylic acid or an ester-forming derivative thereof, an aromatic polyester diol obtained by a reaction of an aliphatic diol and an aromatic dicarboxylic acid or an ester-forming derivative thereof, and the like. Further, examples of the polyether diol include polyethylene glycol, polypropylene glycol and polytetramethylene glycol and block copolymers thereof, and the like. Moreover, examples of the polycarbonate diol include a polycarbonate diol obtained by a reaction of an aliphatic diol and a carbonate compound, a polycarbonate diol obtained by a reaction of an aromatic diol such as bisphenol A and a carbonate compound, and the like. These high molecular weight diols can be used alone or in combination of two or more.

As the chain extension agent mentioned above, conventionally known chain extension agents can be used. Examples of the chain extension agent include e.g., a low molecular weight compound having a molecular weight of 300 or less and having two or more active hydrogen atoms that can react with an isocyanate group in the molecule, for example, a diol such as ethylene glycol, propylene glycol, 1,4-butanediol, 1,6-hexanediol, 1,4-bis(β-hydroxyethoxy)benzene, 1,4-cyclohexanediol, bis-(β-hydroxyethyl)terephthalate and xylylene glycol; a diamine such as hydrazine, ethylenediamine, propylenediamine, xylylenediamine, isophoronediamine, piperazine and derivatives thereof, phenylenediamine, tolylenediamine, xylenediamine, adipic acid dihydrazine and isophthalic acid dihydrazine; an amino alcohol such as aminoethyl alcohol and aminopropyl alcohol, and the like. These can be used alone or in combination of two or more.

Examples of the polyamide-based polymer include a copolymer composed of a hard segment formed from polyamide, and a soft segment formed from polyester, polyether, polyester•polyether, and the like.

Examples of the polyamide segment include a segment derived from an aminocarboxylic acid of 6 or more carbons such as ω-aminocaproic acid, ω-aminoenanthic acid, ω-aminocaprylic acid, ω-aminopergon acid, ω-aminocapric acid, 11-aminoundecanoic acid and 12-aminododecanoic acid; a segment derived from a lactam such as caprolactam and laurylolactam; a segment derived from a diamine component such as ethylenediamine, 1,2-propylenediamine, 1,3-propylenediamine, 1,4-butanediamine, 1,5-pentanediamine, 3-methyl-1,5-pentanediamine, 1,6-hexanediamine, 1,7-heptanediamine, 1,8-octanediamine, 2-methyl-1,8-octanediamine, 1,9-nonanediamine, 1,10-decanediamine, 1,11-undecanediamine, 1,12-dodecanediamine and cyclohexanediamine, and a dicarboxylic acid component such as glutaric acid, adipic acid, pimelic acid, suberic acid, azelaic acid, sebacic acid, dodecanedioic acid, terephthalic acid, isophthalic acid, orthophthalic acid, naphthalene-2,6-dicarboxylic acid, diphenyl-4,4'-dicarboxylic acid and diphenoxyethane dicarboxylic acid, and the like.

Examples of the polyester segment include a segment derived from a hydroxycarboxylic acid such as ω-oxycarboxylic acid; a segment derived from a lactone such as ε-caprolactone; a segment derived from a dicarboxylic acid component such as glutaric acid, adipic acid, pimelic acid, suberic acid, azelaic acid, sebacic acid, dodecanedioic acid, terephthalic acid, isophthalic acid, orthophthalic acid, naphthalene-2,6-dicarboxylic acid, diphenyl-4,4'-dicarboxylic acid and diphenoxyethane dicarboxylic acid, and a diol component such as ethylene glycol, diethylene glycol, triethylene glycol, tetraethylene glycol, 1,2-propylene glycol, 1,3-propylene glycol, 1,4-butanediol, 1,3-butanediol, neopentylglycol, 1,5-pentanediol, 3-methyl-1,5-pentanediol, 1,6-hexanediol, 1,7-heptanediol, 1,8-octanediol, 2-methyl-1,8-octanediol, 1,9-nonanediol, 1,10-decanediol, cyclohexane dimethanol and cyclohexane diol, and the like.

In addition, examples of the polyether segment mentioned above include segments of polymethylene glycol, polyethylene glycol, polypropylene glycol, polytetramethylene glycol, polyhexamenthylene glycol and the like.

Furthermore, examples of the polyester polyether segment include a segment derived from the dicarboxylic acid component in the polyester segment mentioned above, and a diol component such as polymethylene glycol, polyethylene glycol, polypropylene glycol, polytetramethylene glycol and polyhexamethylene glycol, and the like.

Examples of the polyester-based polymer include a polyester • polyether type polymer having a hard segment formed from a polyester such as polybutylene terephthalate, and a soft segment formed from a polyether such as polytetramethylene glycol ether (PTMG) and PTMEGT (condensate of PTMG and terephthalic acid); a polyester•polyester type polymer having a hard segment formed from a polyester, and a soft segment formed from an aliphatic polyester such as polycaprolactone; and the like.

Examples of the fluorine-based polymer include a polymer obtained with a monomer containing vinylidene fluoride, and the like. Examples of the other monomer include perfluorovinyl ether, tetrafluoroethylene, hexafluoropropylene, chlorotrifluoroethylene, ethylene, propylene, a crosslinkable compound and the like.

Among the polymers exemplified above, a diene-based polymer and an olefin-based polymer are preferred as the polymer to be contained in the flexible polymer composition. These polymers having a specific structure as described lead to a molded article having transparency.
And even in the case where it is adhered to, for example, a transparent glass, a plastic article or the like, reduction of the transparency never causes.
The polymer contained in the flexible polymer composition according to the present invention can be used in an arbitrary combination of a polymer such as ethylene•vinyl acetate copolymer, a styrene-based polymer, polycarbonate, polyacetal and epoxy-based polymer, in addition to the above polymer.

The flexible polymer composition according to the present invention may be one consisting of only the polymer exemplified above, or may comprise an additive and the like in an amount not to deteriorate the transparency of the molded article. Examples of the additive include a softening agent, a plasticizer, a lubricant, a crosslinking agent, a crosslinking aid, an antioxidant, an anti-aging agent, a heat stabilizer, a flame retardant, an antibacterial • antifungal agent, a weather resistant agent, an ultraviolet ray absorbing agent, an adhesiveness imparting agent, a core forming agent, a pigment, a dye, an organic filler, an inorganic filler, a silane coupling agent, a titanium coupling agent and the like.

The transparent sealant for organic EL element of the invention has not only transparency, but also flexibility. According to the invention, there is a case in which only the polymer contained in the flexible polymer composition is used for the transparent sealant for organic EL element, and a case in which at least a part of the polymer contained in the flexible polymer composition is allowed to be crosslinked to give the transparent sealant for organic EL element. In the latter case, heat resistance may be further improved through forming the crosslinking structure.

In the case of producing a transparent sealant for organic EL element of the present invention by crosslinking at least a part of the polymer contained in the flexible polymer composition, a crosslinking agent may be used. Examples thereof include an organic peroxide, sulfur, a sulfur-containing compound and the like.
Examples of the organic peroxide include t-butyl hydroperoxide, 1,1,3,3-tetramethylbutyl hydroperoxide, p-menthane hydroperoxide, cumene hydroperoxide, diisopropylbenzene hydroperoxide, 2,5-dimethylhexane-2,5-dihydroperoxide, 1,1-di-t-butylperoxy-3,3,5-trimethylcyclohexane, di-t-butyl peroxide, t-butylcumyl peroxide, dicumyl peroxide, 1,1-bis(t-butylperoxy)cyclododecane, 2,2-bis(t-butylperoxy)octane, 1,1-di-t-butylperoxycyclohexane, 2,5-dimethyl-2,5-di-(t-butylperoxy)hexane, 2,5-dimethyl-2,5-di-(t-butylperoxy)hexine, 1,3-bis(t-butylperoxy-isopropyl)benzene, 2,5-dimethyl-2,5-di-(benzoylperoxy)hexane, 1,1-bis(t-butylperoxy)-3,3,5-trimethylcyclohexane, n-butyl-4,4-bis(t-butylperoxy)valerate, benzoyl peroxide, m-toluyl peroxide, p-chlorobenzoyl peroxide, 2,4-dichlorobenzoyl peroxide, t-butylperoxy isobutyrate, t-butylperoxy-2-ethyl hexanoate, t-butylperoxy benzoate, t-butylperoxy-isopropyl carbonate, t-butylperoxyallyl carbonate and the like. These can be used alone or in combination of two or more.

Furthermore, when a chemical crosslinking structure or a structure having a bound point that is similar thereto is formed in a copolymer obtained using the cyclic compound represented by the above general formula (1), a metal ion, a metal compound and the like can be used. The metal ion means the ions of the element illustrated below, and the ions of the metal compounds comprising such element. Examples of the metal include element in groups I to VIII of periodic table such as lithium, sodium, potassium, aluminum, magnesium, calcium, barium, cesium, strontium, rubidium, titanium, zinc, copper, iron, tin, lead and zirconium. The ion comprising such an element can also form a crosslinking structure between the copolymers by an ionic bond or an electrostatic bond to the functional group in the random copolymer obtained as described above. Examples of a material for forming the ion of the metal compound mentioned above include an oxide, a hydroxide, a salt, a complexe of each metal (metal carboxylate, metal acetylacetonate and the like), an organic compound comprising the metal element (alkoxides and the like the carbon number of which is selected from 1 to 8, and which comprises a metal element), and the like.

The amount of the material for the above ion to be used is preferably 0.01 to 50 equivalents, more preferably 0.1 to 10 equivalents and particularly preferably 0.2 to 5 equivalents per 1 equivalent of the unit formed from the cyclic compound, constituting the copolymer obtained using the cyclic compound represented by the above general formula (1). If the amount of the material for the above ion to be used is too small, the resulting molded article tends to have low crosslinking density or bound point density, and to be inferior in mechanical strength and heat resistance. On the other hand, if the amount of the material for the above ion to be used is too much, the resulting molded article may have so high crosslinking density or bound point density that it may be fragile due to too much hardness.

Additionally, in order to improve miscibility of the material for the above ion in connection with the copolymer obtained using the cyclic compound represented by the above general formula (1), and heat resistance of the resulting molded article, a metal salt of an organic acid such as carboxylic acid may be added as an active agent in addition to the material for the above ion. A metal salt of a monovalent carboxylic acid of 3 to 23 carbons is preferably used as the metal salt.
Further, the metal element in the metal salt which may be used as the active agent may be selected from metal element constituting the material for the above ion, however, it is preferred to use a metal salt comprising the same type of the element as the metal element constituting the material for the above ion.

In the present invention, the flexible polymer composition comprises preferably a liquid material in order to obtain a molded article having further improved flexibility. The additive component mentioned above as the liquid material may be used as is so long as it has a kinematic viscosity at 40°C of preferably 800 mm²/s (1 cm²/s = 1 St) or less, more preferably 600 mm²/s or less and still preferably 0.1 to 500 mm²/s, and leads to a molded article further improved flexibility. That is, a softening agent, a plasticizer, a lubricant, a liquid polymer and the like can be suitably used as the liquid material so long as it is a substance having a kinematic viscosity that meets the requirement.

Examples of the softening agent include a natural or synthetic petroleum-based softening agents such as paraffin oil, ethylene • α-olefin-based oligomer, a mineral oil-based softening agent such as gilsonite, a fatty acid such as oleic acid and ricinoleic acid, and the like. Examples of the plasticizer include a derivative of various fatty acids such as phthalic acid derivatives, isophthalic acid derivatives, tetrahydrophthalic acid derivatives, adipic acid derivatives, sebacic acid derivatives, fumaric acid derivatives, citric acid derivatives, azelaic acid derivatives, phosphoric acid derivatives, maleic acid derivatives and the like. Examples of the lubricant include a paraffin-based lubricant, a hydrocarbon-based lubricant, a metal soap and the like. Furthermore, examples of the liquid polymer include a liquid rubber such as liquid polybutadiene and liquid styrene•butadiene rubber, polyisobutylene, silicone oil and the like. The liquid material as exemplified may be used alone or in combination of two or more.

The amount of the liquid material to be used is preferably from 50 to 5000 parts by mass, more preferably from 50 to 4000 parts by mass, still preferably from 50 to 3000 parts by mass and particularly preferably 70 to 2000 parts by mass based on 100 parts by mass of the total amount of the polymer contained in the flexible polymer composition. If the blending amount of the liquid material is less than 50 parts by mass, a molded article having a desired elastic modulus may not be provided. On the other hand, if the blending amount of the liquid material is beyond 5000 parts by mass, the liquid material may exude out of the molded article, and thus persistence of the transparency may be difficult.

Using the flexible polymer composition described above, a molded article having a desired shape can be obtained by a known method such as injection molding, extrusion molding, blow molding, compression molding, vacuum molding, lamination molding, calender molding, cast molding, coater molding, roll molding, T die coater, T die extrusion molding and infusion molding. Thus resulting molded article is excellent in transparency, the haze thereof is preferably less than 5%, more preferably 4.5% or less and still preferably 4% or less when the thickness is 0.5 mm. Additionally, the total transmittance of the resulting molded article is preferably 90% or higher, more preferably 91% or higher and still preferably 92% or higher. The total transmittance can be achieved in a wide range of the temperature, for example, in the range from -100 to 110°C, and preferably from -50 to 100°C. The method of measuring the haze and the total transmittance will be described later.

Additionally, the resulting molded article has excellent strength and flexibility. Under the conditions at 30°C and at 1 Hz in measurement of dynamic viscoelasticity, shear storage modulus (G') of the resulting molded article is preferably 1 × 10¹⁰ dyn/cm² or less, more preferably 1 × 10⁸ dyn/cm² or less and still preferably 1 × 10⁶ dyn/cm² or less, and usually 1 dyn/cm² or greater. The method of measuring the shear storage modulus will be described later.
Moreover, the resulting molded article is also excellent in heat resistance. That is, the resulting molded article has flexibility, transparency and shape-retentive property all together at preferably in the range from -80 to 110°C, and more preferably from -50 to 100°C.

Since the transparent sealant for organic EL element of the present invention has properties as described, it is suited for sealing a whole of the light emitting element at least, and further for filling a space surrounding the light emitting element.
The shape of the transparent sealant for organic EL element of the present invention is not limited, but may be one that is fitted to the shape of the space. In addition, the sealant may be a thin-walled body having a thin-walled part, and a plate body, a concave-like body or the like may be also formed. The thickness of the thinnest part in such a case can be preferably 2000 µm or less, more preferably 0.1 to 2000 µm, still preferably 0.1 to 1000 µm, particularly preferably 0.1 to 500 µm, and yet preferably 0.1 to 100 µm.

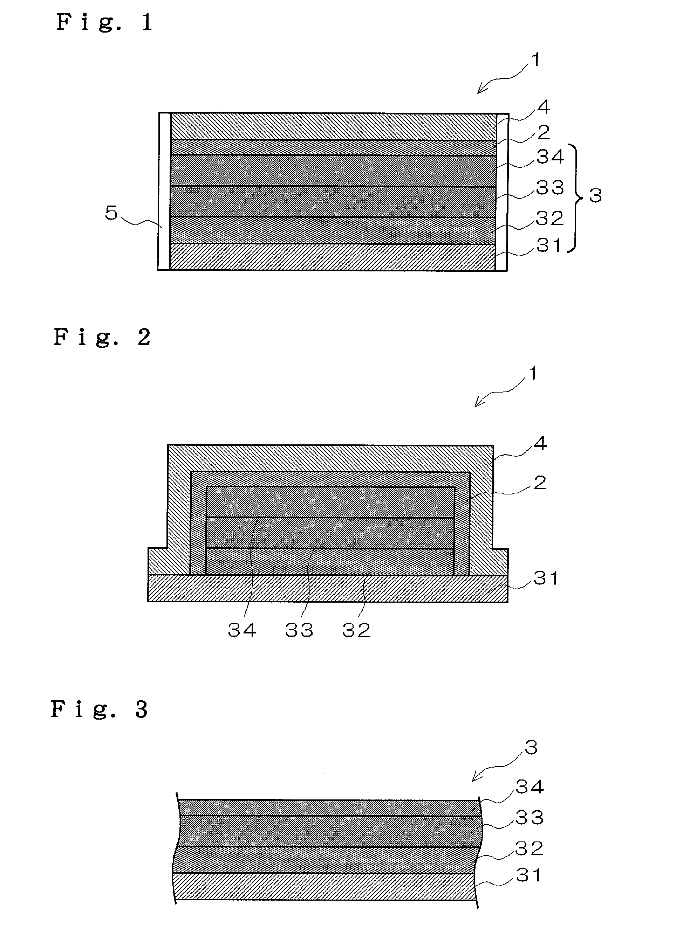

The transparent sealant for organic EL element of the present invention can be disposed at, for example, a predetermined position of the EL display panel 1 shown in Fig. 1. More specifically, the mode shown in Fig. 1 is an explanatory drawing, which a transparent sealant 2 for organic EL element is disposed to adhere on both of a light emitting face (upper face in Fig. 1) of a light emitting element 3 shown in Fig. 3 (constituting members 31 to 34 in Fig. 1) and a sealing member 4 so that the space therebetween is filled. As described above, since the transparent sealant for organic EL element of the present invention is excellent in flexibility, it can be adhered so that the light emitting element can be sufficiently sealed, thereby improving visibility of the image.

Moreover, the transparent sealant for organic EL element of the present invention can be also used in the mode shown in Fig. 2. That is, it can be also disposed so as to fill the space between the light emitting face (upper face in Fig. 2) of the light emitting element (constituting members 31 to 34 in Fig. 1) and the sealing member 4 (may be also referred to as "sealing can" for one having a shape shown in Fig. 2).
Method of using the transparent sealant for organic EL element of the present invention is not limited to modes as shown in Fig. 1 and Fig. 2, but any disposing method can allow for persistence of properties as explained in the foregoing for a long period of time. In other words, the transparent sealant for organic EL element of the present invention is not deteriorated with using time. And it is less damaged on the light emitting element as well as scarcely generating dark spots.

The sealing member (represented by numeral 4 in Fig. 1 and Fig. 2) may be of a material having a property not to greatly inhibit the visibility of the display content on the display panel. As the material constituting the sealing member, for example, a glass, a resin or the like can be used. Examples of the glass include a borosilicate glass, an aluminosilicate glass, an aluminoborosilicate glass, a silica glass, a low alkali glass, a soda lime glass and the like. Further, examples of the resin include a polycarbonate-based resin, a polyacetal-based resin, 1,2-polybutadiene resin, an ethylene • vinyl acetate copolymer preferably containing 3% by mass or more vinyl acetate unit, an olefin-based resin such as polyethylene and polypropylene, a styrene based-resin, an acrylic resin, a vinyl ester-based resin, a saturated polyester-based resin, a polyamide-based resin, a fluorine resin such as vinylidene polyfluoride, an urethane-based resin, an epoxy-based resin, an unsaturated polyester-based resin, a silicone-based resin and the like.
The shape of the sealing member mentioned above may be plate-like as shown in Fig. 1, or may be a lid type shape that covers the light emitting member as shown in Fig. 2.

### [Examples]

Hereinafter, the present invention will be explained in detail by way of examples. The invention is not anyhow limited by these examples. Furthermore, "%" and "part" in examples are based on the mass unless otherwise specified.

### 1. Preparation of flexible polymer composition

The polymer obtained by the method described below and the liquid material were mixed at a ratio shown in Table 1 to prepare flexible polymer compositions (i) to (vii).

### 1-1. Polymer

### (1) Hydrogenation of butadiene block polymer (A1)

25 kg of cyclohexane, 1 g of tetrahydrofuran, 1,500 g of butadiene and 3.9 g of n-butyl lithium were charged into a nitrogen-replaced reactor whose inner volume was 50 L, and an adiabatic polymerization at 70°C was carried out. After the reaction was completed, the temperature of the reaction solution was brought to 40°C. Subsequently 100 g of tetrahydrofuran and 3,500 g of 1,3-butadiene were added and an adiabatic polymerization was carried out. After 30 minutes, 2.7 g of methyldichlorosilane was added and a reaction was carried out for 15 minutes to complete a reaction.
Next, hydrogen gas was supplied at a pressure of 0.4 MPa-G to react with lithium at terminal of the polymer which is living as a living anion for 20 minutes while stirring the reaction solution to a lithium hydride. After that, the temperature of the reaction solution was brought to 90°C and 0.8 g of tetrachlorosilane was further added and stirred for 20 minutes. Subsequently, a catalyst for hydrogenation including mainly a titanocene compound was added to the reaction solution, a hydrogenation reaction was carried out for 2 hours by controlling supplying pressure of the hydrogen gas to 0.8 MPa. At the time when hydrogen absorption was completed, the reaction solution was brought to normal temperature and normal atmosphere, and taken out of the reactor. Then, the reaction solution was added to water while stirring and the solvent was removed by steam stripping, whereby a hydrogenated block polymer A1 was obtained. The degree of hydrogenation of the obtained hydrogenated block polymer A1 was 99%, the weight average molecular weight was 340,000, the vinyl bond content of butadiene polymer block at the first stage polymerization before hydrogenation was 15%, and the vinyl bond content of butadiene polymer block at the second stage polymerization before hydrogenation was 49%.

### (2) Hydrogenation of butadiene block polymer (A2)

25 kg of cyclohexane, 1 g of tetrahydrofuran, 1,500 g of butadiene and 4.1 g of n-butyl lithium were charged into a nitrogen-replaced reactor whose inner volume was 50 L, and an adiabatic polymerization at 70°C was carried out. After the reaction was completed, the temperature of the reaction solution was brought to 35°C. Subsequently 27 g of tetrahydrofuran and 3,500 g of 1,3-butadiene were added and an adiabatic polymerization was carried out. After 30 minutes, 2.9 g of methyldichlorosilane was added and a reaction was carried out for 15 minutes to complete a reaction.
Next, hydrogen gas was supplied at a pressure of 0.4 MPa-G to react with lithium at terminal of the polymer which is living as a living anion for 20 minutes while stirring the reaction solution to a lithium hydride. After that, the temperature of the reaction solution was brought to 90°C and 0.9 g of tetrachlorosilane was further added and stirred for 20 minutes. Subsequently, a catalyst for hydrogenation including mainly a titanocene compound was added to the reaction solution, a hydrogenation reaction was carried out for 2 hours by controlling supplying pressure of the hydrogen gas to 0.8 MPa. At the time when hydrogen absorption was completed, the reaction solution was brought to normal temperature and normal atmosphere, and taken out of the reactor. Then, the reaction solution was added to water while stirring and the solvent was removed by steam stripping, whereby a hydrogenated block polymer A2 was obtained. The degree of hydrogenation of the obtained hydrogenated block polymer A2 was 99%, the weight average molecular weight was 290,000, the vinyl bond content of butadiene polymer block at the first stage polymerization before hydrogenation was 14%, and the vinyl bond content of butadiene polymer block at the second stage polymerization before hydrogenation was 35%.

### (3) Hydrogenation of butadiene block polymer (A3)

25 kg of cyclohexane, 1 g of tetrahydrofuran, 1,500 g of butadiene and 4.1 g of n-butyl lithium were charged into a nitrogen-replaced reactor whose inner volume was 50 L, and an adiabatic polymerization at 70°C was carried out. After the reaction was completed, the temperature of the reaction solution was brought to 5°C.
Subsequently 350 g of tetrahydrofuran and 3,500 g of 1,3-butadiene were added and an adiabatic polymerization was carried out. After 30 minutes, 2.9 g of methyldichlorosilane was added and a reaction was carried out for 15 minutes to complete a reaction.
Next, hydrogen gas was supplied at a pressure of 0.4 MPa-G to react with lithium at terminal of the polymer which is living as a living anion for 20 minutes while stirring the reaction solution to a lithium hydride. After that, the temperature of the reaction solution was brought to 90°C and 0.9 g of tetrachlorosilane was further added and stirred for 20 minutes. Subsequently, a catalyst for hydrogenation including mainly a titanocene compound was added to the reaction solution, a hydrogenation reaction was carried out for 2 hours by controlling supplying pressure of the hydrogen gas to 0.8 MPa. At the time when hydrogen absorption was completed, the reaction solution was brought to normal temperature and normal atmosphere, and taken out of the reactor. Then, the reaction solution was added to water while stirring and the solvent was removed by steam stripping, whereby a hydrogenated block polymer A3 was obtained. The degree of hydrogenation of the obtained hydrogenated block polymer A3 was 99%, the weight average molecular weight was 300,000, the vinyl bond content of butadiene polymer block at the first stage polymerization before hydrogenation was 15%, and the vinyl bond content of butadiene polymer block at the second stage polymerization before hydrogenation was 78%.

### (4) Hydrogenation of diene-based polymer (A4)

25 kg of cyclohexane, 1 g of tetrahydrofuran, 200 g of styrene and 4.1 g of n-butyl lithium were charged into a nitrogen-replaced reactor whose inner volume was 50 L, and an adiabatic polymerization at 50°C was carried out. After the reaction was completed, the temperature of the reaction solution was brought to 10°C. Subsequently 750 g of tetrahydrofuran, 200 g of styrene and 4,500 g of 1,3-butadiene were added and an adiabatic polymerization was carried out.
Next, hydrogen gas was supplied at a pressure of 0.4 MPa-G to react with lithium at terminal of the polymer which is living as a living anion for 20 minutes while stirring the reaction solution to a lithium hydride. After that, the temperature of the reaction solution was brought to 90°C and a catalyst for hydrogenation including mainly a titanocene compound was added to the reaction solution, a hydrogenation reaction was carried out for 2 hours by controlling supplying pressure of the hydrogen gas to 0.8 MPa. At the time when hydrogen absorption was completed, the reaction solution was brought to normal temperature and normal atmosphere, and taken out of the reactor. Then, the reaction solution was added to water while stirring and the solvent was removed by steam stripping, whereby a hydrogenated block polymer A4 was obtained. The degree of hydrogenation of the obtained hydrogenated block polymer A4 was 99%, the weight average molecular weight was 300,000, the vinyl bond content of butadiene polymer block at the first stage polymerization before hydrogenation was 15%, and the vinyl bond content of butadiene polymer block at the second stage polymerization before hydrogenation was 80%.

### (5) Olefin-based polymer (A5)

100 parts of a functional group-containing olefin-based copolymer which comprises 75.1 mol% of a structural unit derived from ethylene, 22.8 mol% of a structural unit derived from propylene, 1.8 mol% of a structural unit derived from 5-ethylidene-2-norbornene and 0.3 mol% of a structural unit derived from 8-methyl-8-carboxytetracyclo[4.4.0.1^{2,5}.1^{7,10}]-3-dodecene, and has a weight-average molecular weight (Mw) of 16.0 × 10⁴ was dissolved in 1,000 parts of toluene. Thereafter, one equivalent of zirconium (IV) butoxide (85% 1-butanol solution (manufactured by Wako Pure Chemical Industries, Ltd.) used) per 1 equivalent of the functional group in the functional group-containing olefin-based copolymer was added. And stirring was performed at 80°C for 1 hour, and toluene was removed to obtain polymer A5.

### 1-2. Liquid material

B1; Mineral oil-based softening agent having a kinematic viscosity at 40°C of 30.85 mm²/s (manufactured by Idemitsu Kosan Co., Ltd., trade name "PW-32").
B2; Mineral oil based softening agent having a kinematic viscosity at 40°C of 95.54 mm²/s (manufactured by Idemitsu Kosan Co., Ltd., trade name "PW-90").
B3; Mineral oil based softening agent having a kinematic viscosity at 40°C of 381.6 mm²/s (manufactured by Idemitsu Kosan Co., Ltd., trade name "PW-380").

In addition, thermoplastic polyurethane (manufactured by Kuraray Co., Ltd., trade name "Kuramilon U1190") A6 was used as a flexible polymer composition (viii) for use in Comparative Example.

**Table 1**

| | | Flexible polymer composition | | | | | | | | | |
|---|---|---|---|---|---|---|---|---|---|---|---|
| | | (i) | (ii) | (iii) | (iv) | (v) | (vi) | (vii) | (viii) | (ix) | (x) |
| Polymer (parts) | A1 | 100 | 100 | 100 | | | 100 | | | | |
| | A2 | | | | 100 | | | | | | |
| | A3 | | | | | 100 | | | | | |
| | A4 | | | | | | | 100 | 100 | | |
| | A5 | | | | | | | | | 100 | |
| | A6 | | | | | | | | | | 100 |
| Liquid material (parts) | B1 | 1,600 | 800 | 400 | | | | | | | |
| | B2 | | | | 800 | 800 | | | 100 | | |
| | B3 | | | | | | 800 | | | | |

### 2. Production and evaluation of transparent sealant for organic EL element

### Example 1

Using the flexible polymer composition (i), a plate thin thin-walled body was produced by coater molding to obtain a transparent sealant for organic EL element. This transparent sealant for organic EL element was evaluated according to the following method. The results are shown in Table 2.
(1) Total transmittance and Haze
   A thin-walled body having a thickness of 0.5 mm was sandwiched between two molten molded aluminosilicate thin glass plates having a thickness of 0.7 mm (manufactured by Corning Incorporated, trade name "Corning 1737"), and total transmittance (%) and haze (%) at 25°C were measured with an apparatus for measuring total transmittance haze (manufactured by BYK-Gardner, trade name "Haze-gard plus4725"). The transparency was graded as "○" when the haze is less than 5% exhibiting excellent transparency, and graded as "×" when the haze is 5% or more exhibiting inferior transparency.
(2) Visibility of Image
   A printed matter was adhered to the transparent sealant for organic EL element having a thickness of 500 µm, and visibility of the printed matter was determined by visual observation. It was graded as "○" in satisfactory case, and graded as "×" in unsatisfactory case.
(3) Viscoelasticity
   Shear storage modulus (G') and tanδ were measured with an apparatus for measuring dynamic viscoelasticity (manufactured by Rheology "MR-500") under conditions at 30°C and at 1 Hz. G' was also measured under conditions at 70°C and at 1 Hz. When the shear storage modulus is beyond two million, the flexibility was evaluated to be inferior, and when it is two million or less, the flexibility was evaluated to be excellent.
(4) Sealing Property
   A light emitting element 3 was produced which has an anode layer 32 on a substrate 31 made of an insulative transparent glass, a light emitting layer 33 on the upper face thereof, and further a cathode layer 34 on the upper face thereof (see, Fig. 3). Subsequently, the transparent sealant 2 for organic EL element having a thickness of 500 µm produced using the flexible polymer composition (i) was placed to stand on the upper face of the cathode layer 34 of the light emitting element 3. Thereafter, an insulative transparent glass as the sealing member 4 was placed on the upper face of the transparent sealant 2 for organic EL element to produce a model of an EL display panel (see, Fig. 1). Accordingly, when the flexible polymer composition is excellent in flexibility and allows close adhesion to fill in the space generated inside of the EL display panel without gap, the sealing property was graded as "○" being excellent, and when the flexible polymer composition is inferior in flexibility and does not allow close adhesion to fill in the space generated inside of the EL display panel without gap, the sealing property was graded as "×" being inferior.
(5) Dark Spot
   Next, the above model was heated at 80°C for 100 hours, and was cooled to room temperature (25°C). Then, the light emitting element was rendered to start, and dark spot (point without light emission) was observed. When the area of dark spots accounts for less than 5% in the entire area, evaluation was made to be "○" as being excellent in suppression of generation of dark spots, and when the area accounts for 5% or greater, evaluation was made to be "×" as being inferior in suppression of generation of dark spots.

### Examples 2 to 6 and 8

Using the flexible polymer compositions (ii) to (vi) and (viii), transparent sealants for organic EL element were obtained in a similar manner to Example 1. Each transparent sealant for organic EL element was evaluated in a similar manner to Example 1. The results are shown in Table 2 together.

### Examples 7 and 9

Using the flexible polymer compositions (vii) and (ix), transparent sealants for organic EL element having a thickness of 500 µm were obtained by hot press at 200°C. Each transparent sealant for organic EL element was evaluated in a similar manner to Example 1. The results are shown in Table 2 together.

### Comparative Example 1

Evaluation was made in a similar manner to Example 7 except that a transparent sealant for organic EL element having a thickness of 500 µm was obtained by hot press at 160°C using the flexible polymer composition (x) (polymer A6). The results are shown in Table 2 together.

**Table 2**

| | | Example | | | | | | | | | Comparative Example |
|---|---|---|---|---|---|---|---|---|---|---|---|
| | | 1 | 2 | 3 | 4 | 5 | 6 | 7 | 8 | 9 | 1 |
| Haze (%) | | 2.4 | 3.2 | 4.5 | 2.5 | 2.6 | 2.6 | 2.1 | 2 | 3 | 29.9 |
| Total transmittance (%) | | 94 | 94 | 93 | 94 | 94 | 94 | 94 | 94 | 93 | 93 |
| Degree of transparency | | ○ | ○ | ○ | ○ | ○ | ○ | ○ | ○ | ○ | × |
| Visibility | | ○ | ○ | ○ | ○ | ○ | ○ | ○ | ○ | ○ | × |
| Storage shear modulus G' (dyn/cm²) | 30°C | 1,900 | 5,800 | 27,300 | 10,700 | 5,500 | 6,100 | 332,000 | 5,800 | 1,240,000 | 4,690,000 |
| | 70°C | 100 | 1,900 | 11,700 | 3,900 | 1,800 | 2,300 | 261,000 | 5,100 | 429,000 | 3,700 |
| Sealing performance | | ○ | ○ | ○ | ○ | ○ | ○ | ○ | ○ | ○ | × |
| Dark spot | | ○ | ○ | ○ | ○ | ○ | ○ | ○ | ○ | ○ | × |

### 3. Results of evaluation

From the result in Table 2, since transparency was inferior in Comparative Example 1, visibility of the image was unsatisfactory. In addition, the area of dark spots was wide. On the other hand, in Examples 1 to 9, transparency and flexibility were excellent and spaces generated inside of the EL display panel were filled without gap by adhering. Further, Examples 1 to 9 had high visibility of the image and generation of dark spots was sufficiently suppressed.

### [Industrial Applicability]

The transparent sealant for organic EL element of the present invention can be suitably used in organic EL display panels with high visibility. The transparent sealant for organic EL element of the invention can be used in mobile phones, portable access to information, desktop computers, laptop computers, televisions, in-vehicle information devices, watches and the like.

## Claims

1. A transparent sealant for organic EL element, which is used in an electroluminescence display panel comprising a light emitting element sequentially including a substrate, an anode layer, a light emitting layer and a cathode layer, and a sealing member disposed on the light emitting side of said light emitting element,
being **characterized in that** said transparent sealant for organic EL element is formed with a flexible polymer composition, and is disposed between the light emitting face of said light emitting element and said sealing member.

2. The transparent sealant for organic EL element according to Claim 1, wherein the total transmittance of said transparent sealant for organic EL element is 90% or higher when it has a thickness of 0.5 mm.

3. The transparent sealant for organic EL element according to Claim 1, wherein said flexible polymer composition is an elastomer composition.

4. The transparent sealant for organic EL element according to Claim 1, wherein said flexible polymer composition comprises at least one polymer selected from the group consisting of a diene-based polymer, an olefin-based polymer, an acrylic-based polymer, an urethane-based polymer, a polyamide-based polymer, a polyester-based polymer, a vinyl chloride-based polymer, a fluorine-based polymer and a silicone-based polymer.

5. The transparent sealant for organic EL element according to Claim 4, wherein said diene-based polymer is at least one polymer selected from the group consisting of a styrene • butadiene copolymer and hydrogenation thereof, a styrene • isoprene copolymer and hydrogenation thereof, a butadiene block copolymer and hydrogenation thereof, a styrene • butadiene • styrene block copolymer and hydrogenation thereof, and a styrene • isoprene • styrene block copolymer and hydrogenation thereof.

6. The transparent sealant for organic EL element according to Claim 4, wherein said diene-based polymer is a hydrogenation of a conjugated diene-based block polymer, in which said conjugated diene block polymer comprising, in its molecule, at least one butadiene polymer block (I) having a vinyl bond in an amount less than 25%, and at least one polymer block (II) having a mass ratio [(a1)/(a2)] of a conjugated diene unit (a1) and other monomer unit (a2) of (100 to 50)/(0 to 50) and having a vinyl bond in an amount from 25 to 95%, is hydrogenated.

7. The transparent sealant for organic EL element according to Claim 4, wherein said diene-based polymer is a hydrogenation of a conjugated diene-based block polymer, in which said conjugated diene block polymer comprising, in its molecule, at least one polymer block having a mass ratio [(b1)/(b2)] of a conjugated diene unit (b1) and an aromatic vinyl compound (b2) of (99 to 50)/(1 to 50), and having a vinyl bond in an amount from 65 to 95%, is hydrogenated.

8. The transparent sealant for organic EL element according to Claim 4, wherein said olefin-based polymer is at least one polymer selected from the group consisting of an ethylene•α-olefin copolymer and an ethylene•α-olefin•non-conjugated diene copolymer.

9. The transparent sealant for organic EL element according to Claim 8, wherein said ethylene•α-olefin copolymer and said ethylene•α-olefin•non-conjugated diene copolymer have a functional group selected from the group consisting of carboxyl group, hydroxyl group, epoxy group, amino group, alkoxysilyl group, sulfonic acid group and nitrile group.

10. The transparent sealant for organic EL element according to Claim 8, further comprising a metal ion and/or a metal compound.

11. The transparent sealant for organic EL element according to Claim 1, wherein said flexible polymer composition comprises a liquid material.

12. The transparent sealant for organic EL element according to Claim 11, wherein the kinematic viscosity of said liquid material at 40°C is 800 mm²/s or lower.

13. The transparent sealant for organic EL element according to Claim 11, wherein the content of said liquid material is in the range from 50 to 5000 parts by mass based on 100 parts by mass of total of the polymer in said flexible polymer composition.

14. The transparent sealant for organic EL element according to Claim 1, wherein said transparent sealant for organic EL element is a thin-walled body having a thickness at the thinnest part of 0.1 to 1,000 µm.
